# EUROPEAN PATENT APPLICATION

(11) **EP 4 579 718 A1**
(43) Date of publication of application: **02.07.2025**
(21) Application number: 24222793.2
(22) Date of filing: 23.12.2024
(51) Int. Cl.: H01L 21/32

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 27.12.2023 JP 2023221870
(71) Applicant: Kokusai Electric Corporation, Tokyo 101-0045 (JP)
(72) Inventor: NAKATANI, Kimihiko, Toyama-shi, Toyama, 939-2393 (JP); HASHIMOTO, Yoshitomo, Toyama-shi, Toyama, 939-2393 (JP)
(74) Representative: Bardehle Pagenberg Partnerschaft mbB Patentanwälte Rechtsanwälte

(57) **Abstract**

There is provided a technique that includes: (a) in a substrate with a structure where surfaces of first, second, and third materials are adjacent to one another sequentially, selectively forming first and second sacrificial films on the surfaces of the first and third materials respectively with respect to the surface of the second material; (b) forming an isolation film in a recess with the first and second sacrificial films as sidewalls; and (c) forming a first recess with one side surface of the isolation film as a sidewall and the surface of the first material as a bottom surface, and a second recess with the other side surface of the isolation film as a sidewall and the surface of the second material as a bottom surface by selectively removing the first and second sacrificial films with respect to the isolation film, the first material, and the third material.

## Description

### CROSS-REFERENCE TO RELATED APPLICATION

This application is based upon and claims the benefit of priority from Japanese Patent Application No. 2023-221870, filed on December 27, 2023, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In the related art, as a process of manufacturing a semiconductor device, a process of forming a film on a surface of a substrate is often performed.

### SUMMARY

Some embodiments of the present disclosure provide a technique capable of precisely forming a film on a substrate.

According to some embodiments of the present disclosure, there is provided a technique that includes: (a) in a substrate with a structure in which a surface of a first material, a surface of a second material, and a surface of a third material are adjacent to one another sequentially, selectively forming a first sacrificial film on the surface of the first material and a second sacrificial film on the surface of the third material respectively with respect to the surface of the second material; (b) forming an isolation film in a recess with the first sacrificial film and the second sacrificial film as sidewalls; and(c) forming a first recess with one side surface of the isolation film as a sidewall and the surface of the first material as a bottom surface, and a second recess with the other side surface of the isolation film as a sidewall and the surface of the second material as a bottom surface by selectively removing the first sacrificial film and the second sacrificial film with respect to the isolation film, the first material, and the third material.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a substrate processing apparatus suitably used in some embodiments of the present disclosure, in which a portion of the process furnace is illustrated in a vertical cross-sectional view.
FIG. 2 is a schematic configuration diagram of the vertical process furnace of the substrate processing apparatus suitably used in some embodiments of the present disclosure, in which the portion of the process furnace is illustrated in a cross-sectional view taken along line A-A in FIG. 1.
FIG. 3 is a schematic configuration diagram of a controller of the substrate processing apparatus suitably used in some embodiments of the present disclosure, in which a control system of the controller is illustrated in a block diagram.

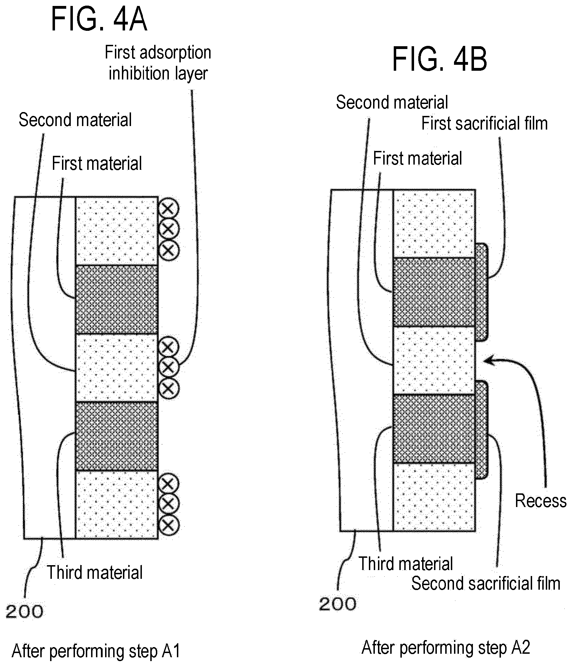

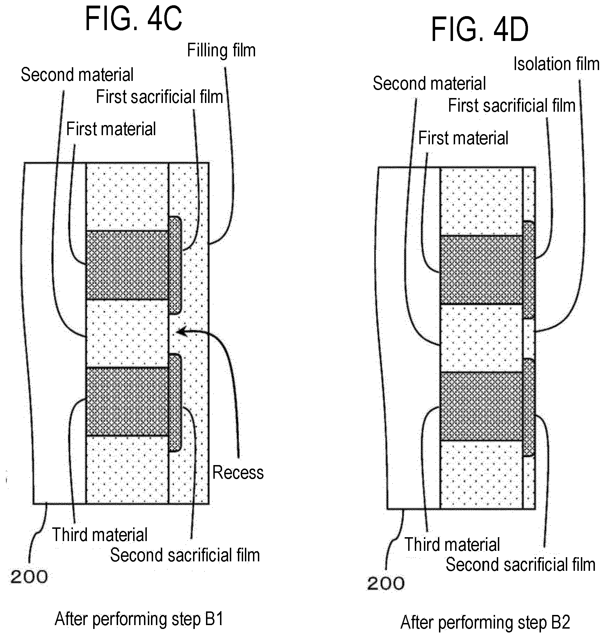

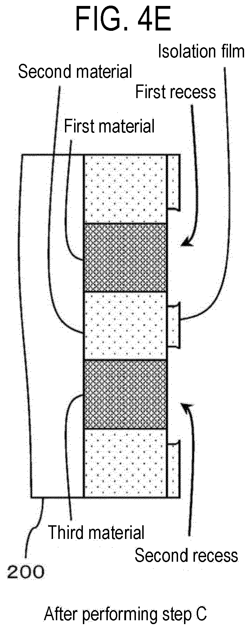

FIG. 4A is a partial cross-sectional enlarged view showing a surface of a wafer in some embodiments of the present disclosure after performing step A1 of forming a first adsorption-inhibiting layer on a surface of a second material. FIG. 4B is a partial cross-sectional enlarged view showing the surface of the wafer in some embodiments of the present disclosure after performing step A2 of forming a first sacrificial film on a surface of a first material and a second sacrificial film on a surface of a third material respectively from a state of FIG. 4A. FIG. 4C is a partial cross-sectional enlarged view showing the surface of the wafer in some embodiments of the present disclosure after performing step B 1 of forming a filling film on the wafer from a state of FIG. 4B. FIG. 4D is a partial cross-sectional enlarged view showing the surface of the wafer in some embodiments of the present disclosure after performing step B2 of removing a portion of the filling film and forming an isolation film on the wafer from a state of FIG. 4C. FIG. 4E is a partial cross-sectional enlarged view showing the surface of the wafer in some embodiments of the present disclosure after performing step C of removing the first sacrificial film and the second sacrificial film from a state of FIG. 4D to form a first recess and a second recess on the wafer.

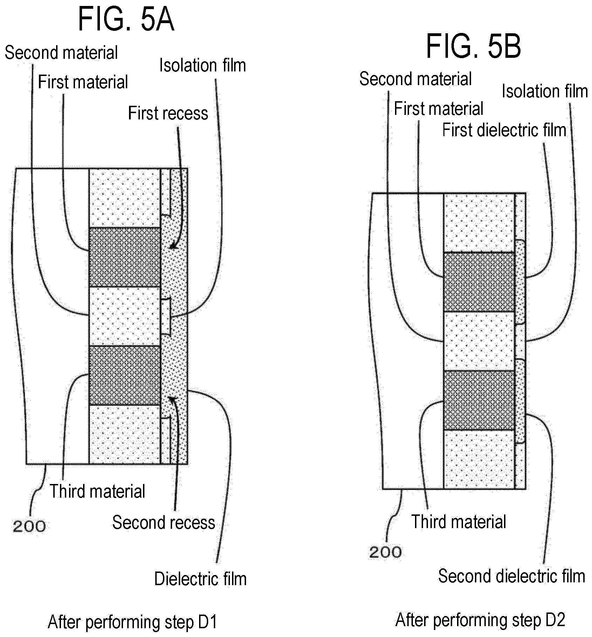

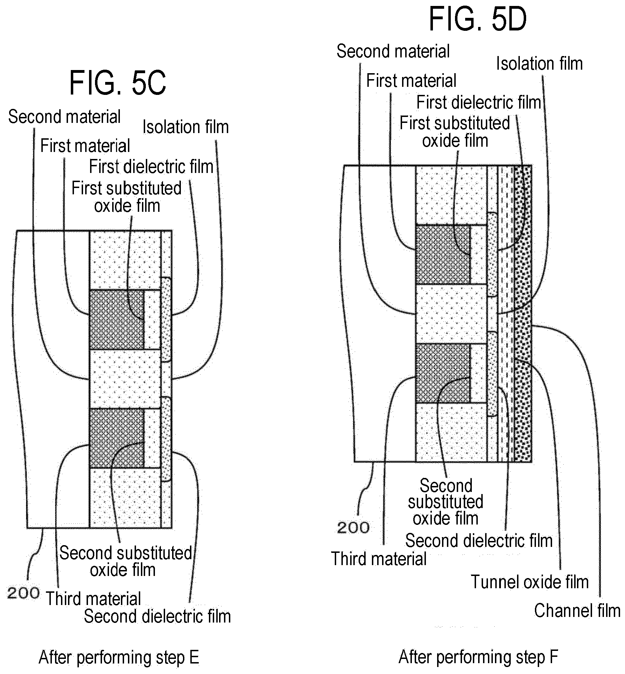

FIG. 5A is a partial cross-sectional enlarged view showing the surface of the wafer in some embodiments of the present disclosure after performing step D1 of forming a dielectric film on the wafer from a state of FIG. 4E. FIG. 5B is a partial cross-sectional enlarged view showing the surface of the wafer in some embodiments of the present disclosure after performing step D2 of removing a portion of the dielectric film and forming a first dielectric film in the first recess and a second dielectric film in the second recess respectively from a state of FIG. 5A. FIG. 5C is a partial cross-sectional enlarged view showing the surface of the wafer in some embodiments of the present disclosure after performing step E of modifying a portion of the first material into a first substituted oxide film and modifying a portion of the third material into a second substituted oxide film from a state of FIG. 5B. FIG. 5D is a partial cross-sectional enlarged view showing the surface of the wafer in some embodiments of the present disclosure after performing step F of sequentially stacking a tunnel oxide film and a channel film on the wafer from the state of FIG. 5B.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiments of Present Disclosure>

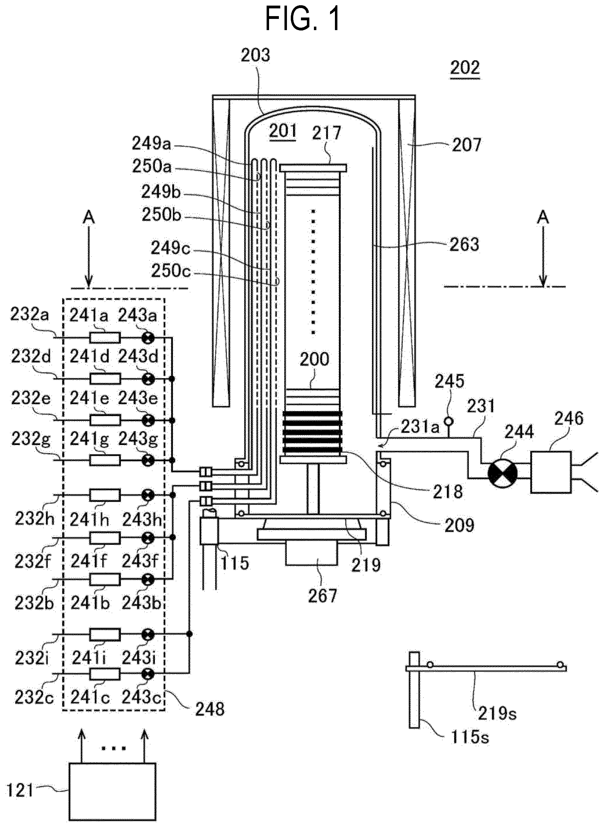

Hereinafter, some embodiments of the present disclosure will be described mainly with reference to FIGS. 1 to 3, 4A to 4E, and 5A to 5D. Further, drawings used in the following description are schematic, and dimensional relationships, ratios, and the like among various components shown in the drawings may not match actual ones. Further, dimensional relationship, ratios, and the like of various components among a plurality of drawings may not match one another.

### (1) Configuration of Substrate Processing Apparatus

As shown in FIG. 1, a process furnace 202 of a substrate processing apparatus includes a reaction tube 203. A manifold 209 is installed below the reaction tube 203. A process container mainly includes the reaction tube 203 and the manifold 209. A process chamber 201 is formed inside the process container. The process chamber 201 is configured to be capable of accommodating wafers 200 as substrates.

A heater 207 configured to heat the wafers 200 in the process chamber 201 is installed outside the reaction tube 203. The heater 207 also functions as an activator configured to thermally activate a gas in the process chamber 201. A temperature sensor 263 is installed inside the reaction tube 203.

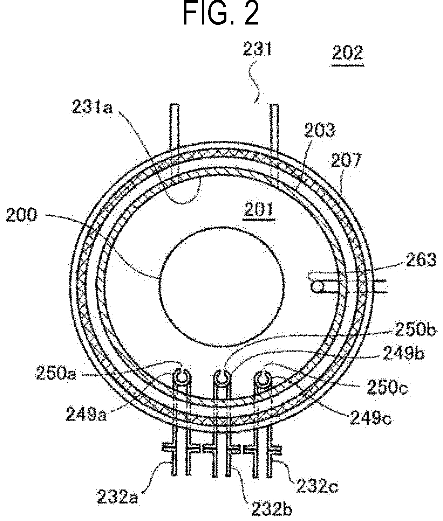

Nozzles 249a to 249c are installed in the process chamber 201. As shown in FIG. 2, the nozzles 249a to 249c are installed to extend upward in an arrangement direction of the wafers 200 along an inner wall of the reaction tube 203. A plurality of gas supply holes 250a to 250c are formed at side surfaces of the nozzles 249a to 249c from a bottom to a top of the reaction tube 203.

Gas supply pipes 232a to 232c are connected to the nozzles 249a to 249c. Mass flow controllers (MFCs) 241a to 241c and valves 243a to 243c are installed at the gas supply pipes 232a to 232c. Gas supply pipes 232d, 232e, and 232g are connected to the gas supply pipe 232a at the downstream side of the valve 243a. Gas supply pipes 232f and 232h are connected to the gas supply pipe 232b at the downstream side of the valve 243b. Gas supply pipe 232i is connected to the gas supply pipe 232c at the downstream side of the valve 243c. MFCs 241d to 241i and valves 243d to 243i are installed at the gas supply pipes 232d to 232i.

A first precursor is supplied from the gas supply pipe 232a into the process chamber 201 via the MFC 241a, the valve 243a, and the nozzle 249a.

Reactants (an oxidizing agent and a nitriding agent) are supplied from the gas supply pipe 232b into the process chamber 201 via the MFC 241b, the valve 243b, and the nozzle 249b.

A modifying agent is supplied from the gas supply pipe 232c into the process chamber 201 via the MFC 241c, the valve 243c, and the nozzle 249c.

A second precursor is supplied from the gas supply pipe 232d into the process chamber 201 via the MFC 241d, the valve 243d, the gas supply pipe 232a, and the nozzle 249a.

A third precursor is supplied from the gas supply pipe 232e into the process chamber 201 via the MFC 241e, the valve 243e, the gas supply pipe 232a, and the nozzle 249a.

A catalyst is supplied from the gas supply pipe 232f into the process chamber 201 via the MFC 241f, the valve 243f, the gas supply pipe 232b, and the nozzle 249b.

An inert gas is supplied from the gas supply pipes 232g to 232i into the process chamber 201 via the MFCs 241g to 241i, the valves 243g to 243i, the gas supply pipes 232a to 232c, and the nozzles 249a to 249c. The inert gas acts as a purge gas, a carrier gas, a dilution gas, or the like.

A first precursor supply system mainly includes the gas supply pipe 232a, the MFC 241a, and the valve 243a. A reactant (an oxidizing agent and a nitriding agent) supply system mainly includes the gas supply pipe 232b, the MFC 241b, and the valve 243b. A modifying agent supply system mainly includes the gas supply pipe 232c, the MFC 241c, and the valve 243c. A second precursor supply system mainly includes the gas supply pipe 232d, the MFC 241d, and the valve 243d. A third precursor supply system mainly includes the gas supply pipe 232e, the MFC 241e, and the valve 243e. A catalyst supply system mainly includes the gas supply pipe 232f, the MFC 241f, and the valve 243f. An inert gas supply system mainly includes the gas supply pipes 232g to 232i, the MFCs 241g to 241i, and the valves 243g to 243i. Any one or the entirety of the above-described various supply systems may be constituted as an integrated supply system 248 in which the valves 243a to 243i, the MFCs 241a to 241i, and so on are integrated. When different reactants are used in the respective processing steps (steps A, B, D, and E) to be described below, a reactant supply system configured to supply the reactant to the nozzle 249c is installed for each of the different reactants.

An exhaust port 231a is installed below the reaction tube 203. A vacuum pump 246 is connected to the exhaust pipe 231 via a pressure sensor 245 and an auto pressure controller (APC) valve 244. An exhaust system mainly includes the exhaust pipe 231, the APC valve 244, and the pressure sensor 245. The vacuum pump 246 may be included in the exhaust system.

A seal cap 219 is installed below the manifold 209. A rotator 267 configured to rotate a boat 217 to described below is provided at the seal cap 219. The seal cap 219 is raised or lowered by a boat elevator 115. The boat elevator 115 functions as a transporter configured to transport the wafers 200 into or out of the process chamber 201.

A shutter 219s capable of air-tightly closing the lower end opening of the manifold 209 is installed below the manifold 209. The opening/closing operation of the shutter 219s is controlled by a shutter opening/closing mechanism 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. At the bottom of the boat 217, heat insulating plates 218 are supported in multiple stages.

Further, the substrate processing apparatus may include a first etching unit (first etching apparatus) configured to perform at least one selected from the group of step B2 (formation of an isolation film) and step D2 (formation of first and second dielectric films) described below. This unit includes, for example, an etching gas supply system configured to supply an etching gas into the process container configured to accommodate the wafers 200, a plasma generator configured to excite the etching gas in the process container into plasma by using an electrode (an antenna) to which a high-frequency power is supplied, a bias regulator configured to regulate a potential (bias) of the wafers 200, and the like. In at least one selected from the group of step B2 and step D2, an anisotropic plasma etching for the wafers 200 may be performed by using this unit.

Further, the substrate processing apparatus may include a second etching unit (a second etching apparatus) configured to perform step C (formation of first and second recesses) to be described below. This unit includes, for example, an etching agent supply system configured to supply an etching agent (an etching solution or an etching gas) to the wafers 200 accommodated in the process container, an immersion vessel configured to immerse the wafers 200 in an etching solution, or the like. In step C, wet etching or dry etching may be performed on the wafers 200 by using this unit. The substrate processing apparatus including at least one selected from the group of the first etching unit and the second etching unit may be constituted as processing systems connected to each other via a communication network.

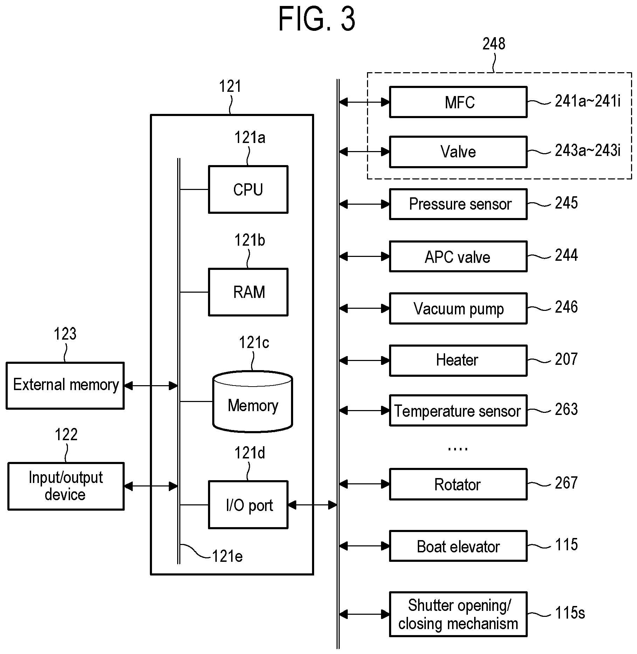

As shown in FIG. 3, the controller 121, which is a control part, is constituted as a computer that includes a CPU 121a, a RAM 121b, a memory 121c, and an I/O port 121d. The RAM 121b, the memory 121c, and the I/O port 121d are configured to be capable of exchanging data with the CPU 121a via an internal bus 121e. An input/output device 122 constituted as a touch panel or the like is connected to the controller 121. An external memory 123 may be connected to the controller 121.

The memory 121c is constituted by a flash memory, a HDD, a SSD, or the like. In the memory 121c, a control program that controls an operation of a processing apparatus, a process recipe in which sequences and conditions of substrate processing to be described below are written, and the like are readably recorded and stored. The process recipe functions as a program that is combined to cause, by the controller 121, the processing apparatus to perform each sequence in the substrate processing to be described below to obtain an expected result. Hereinafter, the process recipe and the control program may be generally and simply referred to as a "program." Further, the process recipe may be simply referred to as a "recipe." When the term "program" is used herein, it may indicate a case of including the recipe, a case of including the control program, or a case of including both the recipe and the control program.

The I/O port 121d is connected to the MFCs 241a to 241i, the valves 243a to 243i, the pressure sensor 245, the APC valve 244, the vacuum pump 246, the temperature sensor 263, the heater 207, the rotator 267, the boat elevator 115, the shutter opening/closing mechanism 115s, and the like. The I/O port 121d may further be connected to the first etching unit and the second etching unit.

The CPU 121a is configured to be capable of reading and executing the control program from the memory 121c and to read the recipe from the memory 121c in response to an input of an operation command from the input/output device 122 or the like. The CPU 121a is configured to be capable of, according to contents of the recipe thus read, controlling the flow rate regulating operation for various substances by the MFCs 241a to 241i, the opening/closing operations of the valves 243a to 243i, the opening/closing operation of the APC valve 244, the pressure regulation operation by the APC valve 244 based on the pressure sensor 245, the start and stop of the vacuum pump 246, the temperature regulation operation of the heater 207 based on the temperature sensor 263, the rotation and the rotation speed adjustment operation of the boat 217 by the rotator 267, the raising or lowering operation of the boat 217 by the boat elevator 115, the opening/closing operation of the shutter 219s by the shutter opening/closing mechanism 115s, and the like. The CPU 121a may be further configured to be capable of controlling the first etching unit and the second etching unit.

The controller 121 may be constituted by installing the above-described program recorded and stored in the external memory 123 into a computer. The external memory 123 includes a magnetic disk such as a HDD, an optical disk such as a CD, a magneto-optical disk such as a MO, a semiconductor memory such as a USB memory or a SSD, and the like. The memory 121c and the external memory 123 are constituted as computer-readable recording media. Hereinafter, these are collectively and simply referred to as a recording medium. When the term "recording medium" is used herein, it may indicate a case of including the memory 121c, a case of including the external memory 123, or a case of including both the memory 121c and the external memory 123. Further, the program may be provided to the computer by using communication means or unit such as the Internet.

### (2) Substrate Processing Process

An example of a processing sequence of forming a film on a surface of a wafer 200 as a substrate, as a process (method) of manufacturing a semiconductor device by using the above-described substrate processing apparatus, will be described mainly with reference to FIGS. 4A to 4E and 5A to 5D. In a series of processing sequences shown below, some steps (steps A1, A2, B1, D1, and E) are performed by the above-described substrate processing apparatus. In this case, an operation of each component constituting the substrate processing apparatus is controlled by the controller 121.

A processing sequence according to the embodiments of the present disclosure includes:
(a) step A of, in a wafer 200 with a structure in which a surface of a first material, a surface of a second material, and a surface of a third material are adjacent to one another sequentially, selectively forming a first sacrificial film on the surface of the first material and a second sacrificial film on the surface of the third material respectively with respect to the surface of the second material;
(b) step B of forming an isolation film in a recess with the first sacrificial film and the second sacrificial film as sidewalls; and
(c) step C of forming a first recess with one side surface of the isolation film as a sidewall and the surface of the first material as a bottom surface, and a second recess with the other side surface of the isolation film as a sidewall and the surface of the second material as a bottom surface by selectively removing the first sacrificial film and the second sacrificial film with respect to the isolation film, the first material, and the third material.

In the following example, a case will be described where, as shown in FIGS. 4A and 4B, step A includes:
(a-1) step A1 of selectively forming a first adsorption inhibition layer that inhibits adsorption of a first precursor on the surface of the second material with respect to each of the surface of the first material and the surface of the third material; and
(a-2) step A2 of forming the first sacrificial film on the surface of the first material and the second sacrificial film on the surface of the third material respectively by supplying the first precursor to the wafer 200.

In the following example, a case will be described where, as shown in FIGS. 4C and 4D, step B includes:
(b-1) step B 1 of forming a filling film that fills the recess and covers at least a portion of an upper surface of each of the first sacrificial film and the second sacrificial film; and
(b-2) step B2 of leaving a portion of the filling film formed in the recess as an isolation film and removing other portions of the filling film.

In the following example, a case will be described where, after performing the above-described step C to form a first recess and a second recess on the surface of the wafer 200, as shown in FIG. 4E, the processing sequence further includes:
(d) step D of forming a first dielectric film in the first recess and a second dielectric film in the second recess respectively.

Specifically, a case will be described where, as shown in FIGS. 5A and 5B, step D includes:
(d-1) step D 1 of forming a dielectric film that fills the first recess and the second recess and covers at least a portion of an upper surface of the isolation film; and
(d-2) step D2 of leaving portions of the dielectric film filling the first recess and the second recess as a first dielectric film and a second dielectric film respectively, and removing other portions of the dielectric film.

Further, in the following example, a case will be described where after performing the step D, as shown in FIG. 5C, the processing sequence further includes:
step E of supplying an oxidizing agent to the wafer 200 to modify a portion of the first material in contact with an interface between the first material and the first dielectric film through the first dielectric film into a first substituted oxide film, and modify a portion of the third material in contact with an interface between the third material and the second dielectric film through the second dielectric film into a second substituted oxide film.

Further, in the following example, a case will be described where after performing the step E, as shown in FIG. 5D, the processing sequence further includes:
step F of sequentially stacking a tunnel oxide film and a channel film on the surface of the wafer 200, i.e., on a surface of each of the isolation film, the first dielectric film, and the second dielectric film formed on the wafer 200.

The term "wafer" used herein may refer to a wafer itself or a stacked body of a wafer and a predetermined layer or film formed on a surface of the wafer. The phrase "a surface of a wafer" used herein may refer to a surface of a wafer itself or a surface of a predetermined layer or the like formed on a wafer. The expression "a predetermined layer is formed on a wafer" used herein may mean that a predetermined layer is directly formed on a surface of a wafer itself or that a predetermined layer is formed on a layer or the like formed on a wafer. The term "substrate" used herein may be synonymous with the term "wafer."

As used herein, terms such as "agent," and "substance" include at least one selected from the group of gaseous substances and liquid substances. Liquid substances include mist-like substances. That is, each of a modifying agent, first to third precursors, and reactants (an oxidizing agent and a nitriding agent) to be described below may include a gaseous substance, a liquid substance such as a mist-like substance, or both.

The processing sequence according to the embodiments of the present disclosure will now be described in detail.

When a plurality of wafers 200 are charged to the boat 217 (wafer charging), the shutter 219s is moved to open the lower end opening of the manifold 209 (shutter opening).
Thereafter, the boat 217 supporting the plurality of wafers 200 is lifted by the boat elevator 115 and loaded into the process chamber 201 (boat loading).

As shown in FIG. 4A and the like, the wafer 200 to be processed includes, on its surface, a structure (hereinafter, also referred to as an adjacent structure) in which the surface of the first material, the surface of the second material, and the surface of the third material are adjacent to one another sequentially. The surface of the wafer 200 may include a three-dimensional structure such as a trench or a hole, and the above-described adjacent structure may be formed at a three-dimensional portion such as a sidewall surface of the trench or the hole. Further, the above-described adjacent structure may also be formed at a flat portion of the surface of the wafer 200. The second material may be an oxide, and each of the first material and the third material may be at least one selected from the group of an oxide with a lower oxygen content ratio (i.e., a lower oxygen content ratio or a lower oxygen content concentration in composition of a material) than the second material, and a non-oxide. For example, each of the first material and the third material may be a nitride such as silicon nitride (SiN), and the second material may be an oxide such as silicon oxide (SiO). Further, each of the first material and the third material may also be a material in which at least a portion of a surface of a nitride such as SiN is native-oxidized. Even in this case, an oxygen content ratio of the native-oxidized surface is lower than that of the second material.

After the boat loading is completed, an inside of the process chamber 201 is vacuum-exhausted (decompression-exhausted) by the vacuum pump 246 such that the inside of the process chamber 201 reaches a desired pressure (a degree of vacuum). Further, the wafers 200 in the process chamber 201 are heated by the heater 207 such that the wafers 200 reach a desired processing temperature. Further, the rotator 267 starts rotation of the wafers 200. The exhaust of the inside of the process chamber 201, and the heating and rotation of the wafers 200 are continued at least until processing of the wafers 200 is completed.

### (Step A)

Subsequently, the following steps A1 and A2 are performed on the wafers 200 prepared in the process chamber 201.

### [Step A1: Formation of First Adsorption Inhibition Layer]

In this step, the valve 243c is opened to supply a modifying agent (inhibitor) to the wafers 200. At this time, the valves 243g to 243i may be opened to supply an inert gas into the process chamber 201.

By performing step A1 under processing conditions to be described below, as shown in FIG. 4A, a first adsorption inhibition layer (a first inhibitor layer) that inhibits adsorption of the first precursor on the surface of the second material may be selectively formed on each of the surface of the first material and the surface of the third material. The first adsorption inhibition layer contains at least a portion of a molecular structure of a molecule that constitutes the modifying agent. In the present disclosure, the phrase "selectively forming the first adsorption inhibition layer on the surface of the second material" does not mean "forming the first adsorption inhibition layer merely on the surface of the second material," but means "preferentially forming the first adsorption inhibition layer on the surface of the second material among the surface of the first material, the surface of the second material, and the surface of the third material". In other words, this phrase does not completely exclude the formation of the first adsorption inhibition layer on the surface of the first material or the formation of the first adsorption inhibition layer on the surface of the third material. The phrase "selectively" is used substantially in the same meaning in the following steps.

After the first adsorption inhibition layer is selectively formed on the surface of the second material, the valve 243c is closed to stop the supply of modifying agent to the wafers 200. Then, the inside of the process chamber 201 is vacuum-exhausted to remove gaseous substances remaining in the process chamber 201 from the inside of the process chamber 201. In addition, the valves 243g to 243i are opened to supply an inert gas into the process chamber 201 to purge the inside of the process chamber 201 (purging).

The modifying agent may be, for example, alkylaminosilane such as (dimethylamino)trimethylsilane ((CH₃)₂NSi(CH₃)₃), (diethylamino)triethylsilane ((C₂H₅)₂NSi(C₂H₅)₃), (dimethylamino)triethylsilane ((CH₃)₂NSi(C₂H₅)₃), (diethylamino)trimethylsilane ((C₂H₅)₂NSi(CH₃)₃), (dipropylamino)trimethylsilane ((C₃H₇)₂NSi(CH₃)₃), or the like.

Further, the modifying agent may be, for example, aminosilane such as tetrakis(dimethylamino)silane (Si[N(CH₃)₂]₄), tris(dimethylamino)silane (Si[N(CH₃)₂]₃H), bis(diethylamino)silane (Si[N(C₂H₅)₂]₂H₂), bis(tertiary butylamino)silane (SiH₂[NH(C₄H₉)]₂), (diisopropylamino)silane (SiH₃[N(C₃H₇)₂]), or the like.

As the modifying agent, one or more of these silicon (Si)-containing substances may be used.

Processing conditions when supplying the Si-containing substance as the modifying agent in step A1 are exemplified as follows:
Processing temperature: room temperature (25 degrees C) to 500 degrees C, specifically, room temperature to 250 degrees C;
Processing pressure: 5 to 1,000 Pa;
Processing time: 1 second to 120 minutes, specifically, 30 seconds to 60 minutes;
Supply flow rate of modifying agent: 0.001 to 3 slm, specifically, 0.001 to 0.5 slm; and
Supply flow rate of inert gas (for each gas supply pipe): 0 to 20 slm.

In the present disclosure, notation of a numerical range such as "25 to 500 degrees C" means that a lower limit value and an upper limit value are included in the range. Therefore, for example, "0 to 500 degrees C" means "0 degrees C or higher and 500 degrees C or lower." The same applies to other numerical ranges. In the present disclosure, the processing temperature means the temperature of the wafer 200 or the internal temperature of the process chamber 201, and the processing pressure means the internal pressure of the process chamber 201. Further, the processing time means a time during which a process is continued. Further, when 0 slm is included in the supply flow rate, 0 slm means a case where no substance (gas) is supplied. The same applies to the following description.

Further, the modifying agent may be fluorine (F₂), nitrogen fluoride (NF₃), chlorine fluoride (ClF₃), hydrogen fluoride (HF), or the like. One or more of these fluorine (F)-containing substances may be used as the modifying agent.

Processing conditions when supplying the F-containing substance as the modifying agent in step A1 are exemplified as follows:
Processing temperature: room temperature (25 degrees C) to 300 degrees C, specifically, room temperature to 200 degrees C;
Processing pressure: 1 to 2,000 Pa, specifically, 1 to 1,000 Pa;
Processing time: 1 second to 60 minutes;
Supply flow rate of modifying agent: 0.001 to 2 slm, specifically, 0.001 to 0.5 slm; and
Supply flow rate of inert gas (for each gas supply pipe): 0 to 20 slm.

In step A1, step A1(Si) of supplying a Si-containing substance as the modifying agent to the wafer 200 and step A1(F) of supplying an F-containing substance as the modifying agent to the wafer 200 may be performed sequentially.

### [Step A2: Formation of First Sacrificial Film and Second Sacrificial Film]

In this step, the following steps (supply of first precursor, and supply of reactant) are performed on the wafer 200 after the first adsorption inhibition layer is formed on the surface of the second material. For example, a nitriding agent may be used as the reactant.

### [Supply of First Precursor]

In this step, the valve 243a is opened to supply a first precursor to the wafer 200. At this time, the valves 243g to 243i may be opened to supply an inert gas into the process chamber 201.

By performing this step (supply of first precursor) under processing conditions to be described below, it is possible to selectively form a first precursor adsorption layer on the surface of each of the first material and the third material with respect to the surface of the second material. The first precursor adsorption layer contains at least a portion of a molecular structure of a molecule constituting the first precursor.

After the first precursor adsorption layer is formed, the valve 243a is closed to stop the supply of first precursor to the wafers 200. Then, by the above-described sequence, gaseous substances remaining in the process chamber 201 are removed from the inside of the process chamber 201, and the inside of the process chamber 201 is purged with an inert gas (purging).

### [Supply of Reactant]

In this step, the valve 243b is opened to supply a reactant to the wafers 200. At this time, the valves 243g to 243i may be opened to supply an inert gas into the process chamber 201.

By performing this step (supply of reactant) under the processing conditions described below, it is possible to modify the first precursor adsorption layer selectively formed on each of the surface of the first material and the surface of the third material. When a nitriding agent is used as the reactant, the first precursor adsorption layer may be nitrided to form a nitride layer containing a constituent element of the first precursor each on the surface of the first material and the surface of the third material.

After the first precursor adsorption layer is modified, the valve 243b is closed to stop the supply of reactant to the wafers 200. Then, by the above-described sequence, gaseous substances remaining in the process chamber 201 are removed from the inside of the process chamber 201, and the inside of the process chamber 201 is purged with an inert gas.

### [Performing Predetermined Number of Times]

Then, a cycle including: the supply of first precursor; and the supply of reactant is performed a predetermined number of times (n_{A} times where n_{A} is an integer of 1 or 2 or more). As a result, as shown in FIG. 4B, it is possible to selectively form the first sacrificial film on the surface of the first material and the second sacrificial film on the surface of the third material respectively with respect to the surface of the second material. When a Si-containing substance is used as the first precursor and a nitriding agent is used as the reactant, nitride films, for example, silicon nitride films (SiN films), may be formed as the first sacrificial film and the second sacrificial film. By forming the first sacrificial film and the second sacrificial film, a recess is formed on the surface of the wafer 200 with the first sacrificial film and the second sacrificial film as sidewalls, and the surface of the second material as a bottom.

The phrase "selectively form the first sacrificial film on the surface of the first material and the second sacrificial film on the surface of the third material respectively with respect to the surface of the second material" does not completely exclude the formation of the first sacrificial film or the second sacrificial film on the surface of the second material, as described above. Therefore, for example, a discontinuous nitride layer may be formed on a portion of the surface of the second material due to a portion of the adsorption inhibition layer being detached during step A2. Further, for example, as shown in FIG. 4B, in step A2, the first sacrificial film may be formed so as to protrude toward the surface of the second material beyond a boundary between the surface of the second material and the surface of the first material (overhang toward, hang from above, cross the boundary into the surface of the second material). This is because, in the process of repeating the cycle of forming the first sacrificial film, the first sacrificial film may grow so as to protrude above the second material by using the first sacrificial film itself as a base. Further, for example, in step A2, the second sacrificial film may be formed so as to protrude toward the surface of the second material beyond the boundary between the surface of the second material and the surface of the third material, just like the first sacrificial film (overhang toward, hang from above, cross the boundary into the surface of the second material). In a case where the discontinuous nitride layer described above is formed on the surface of the second material, the nitride layer may be modified (oxidized) to an oxide equivalent to the second material in step B 1 to be described below.

Further, a thickness of the isolation film to be described below is determined based on thicknesses of the first sacrificial film and the second sacrificial film. Therefore, in step A2, formation of the first sacrificial film and the second sacrificial film is performed until a predetermined thickness corresponding to a desired thickness of the isolation film is reached. Specifically, for example, in step A2, formation of the first sacrificial film and the second sacrificial film is performed until a thickness equivalent to the desired thickness of the isolation film is reached. The thicknesses of the first sacrificial film and the second sacrificial film are larger than the thickness of the first adsorption inhibition layer.

The first precursor may be, for example, the above-described alkylaminosilane or aminosilane. Further, the first precursor may be chlorosilane such as dichlorosilane (SiH₂Cl₂), tetrachlorosilane (SiCl₄), hexachlorodisilane (Si₂Cl₆), octachlorotrisilane (Si₃Cl₈), or the like. As the first precursor, one or more of these Si-containing substances may be used.

The reactant (nitriding agent) may be, for example, hydrogen nitride such as ammonia (NH₃), diazene (N₂H₂), hydrazine (N₂H₄), N₃H₈, and the like. As the reactant, one or more of these nitrogen (N)-containing substances may be used.

Processing conditions when supplying the first precursor in step A2 are exemplified as follows:
Processing temperature: room temperature (25 degrees C) to 500 degrees C, specifically, room temperature to 400 degrees C;
Processing pressure: 1 to 2,000 Pa, specifically, 1 to 1,333 Pa;
Processing time: 1 to 180 seconds, specifically, 10 to 120 seconds;
Supply flow rate of first precursor: 0.001 to 2 slm, specifically, 0.01 to 1 slm; and
Supply flow rate of inert gas (for each gas supply pipe): 0 to 20 slm.

Processing conditions when supplying the reactant in step A2 are exemplified as follows:
Processing pressure: 1 to 4,000 Pa, specifically, 1 to 1,333 Pa; and
Supply flow rate of reactant: 0.01 to 20 slm, specifically, 0.01 to 10 slm.
Other processing conditions may be the same as those used when supplying the first precursor.

As shown herein, each of the first sacrificial film and the second sacrificial film is formed under relatively low temperature processing conditions. Therefore, the first sacrificial film and the second sacrificial film are made of nitride whose density is relatively lower than those of the first material and the third material which are bases of the first sacrificial film and the second sacrificial film. More specifically, the processing temperature of the first sacrificial film and the second sacrificial film may be lower than the processing temperature when forming the first material and the third material which are the bases.

By appropriately selecting the first precursor and the reactant, it is also possible to form a silicon carbonitride film (SiCN film), a silicon carbide film (SiC film), a silicon oxycarbonitride film (SiOCN film), a silicon oxycarbide film (SiOC film), or a silicon oxynitride film (SiON film) as the first sacrificial film and the second sacrificial film. That is, each of the first sacrificial film and the second sacrificial film may be a film containing a predetermined element such as Si or the like and at least one selected from the group of nitrogen and carbon, and may also be a film with a composition different from those of the first material and the third material which are the bases thereof.

### (Step B)

Subsequently, the following steps B1 and B2 are performed on the wafer 200 after the first sacrificial film and the second sacrificial film are formed on the surface of the wafer 200.

### [Step B1: Formation of Filling Film]

In this step, the following steps (a step of supplying a second precursor and a step of supplying a reactant) are performed on the wafer 200. For example, an oxidizing agent may be used as the reactant. In at least one selected from the group of the step of supplying the second precursor and the step of supplying the reactant, a catalyst may be supplied to the wafer 200. The following describes a case where a catalyst is supplied in both the steps of supplying the second precursor and the step of supplying the reactant.

### [Supply of Second Precursor]

In this step, the valves 243d and 243f are opened to supply the second precursor and the catalyst to the wafer 200. At this time, the valves 243g to 243i may be opened to supply an inert gas into the process chamber 201.

By performing this step (supply of second precursor) under processing conditions to be described below, it is possible to form a second precursor adsorption layer in the recess with the first and second sacrificial films as sidewalls and on at least a portion of an upper surface of each of the first and second sacrificial films. The second precursor adsorption layer contains at least a portion of a molecular structure of a molecule constituting the second precursor.

After the second precursor adsorption layer is formed, the valves 243d and 243f are closed to stop the supply of second precursor and the supply of catalyst to the wafer 200. Then, according to the above-described sequence, gaseous substances and the like remaining in the process chamber 201 are removed from the inside of the process chamber 201, and the inside of the process chamber 201 is purged with an inert gas (purging).

### [Supply of Reactant]

In this step, the valves 243b and 243f are opened to supply a reactant and a catalyst to the wafer 200. At this time, the valves 243g to 243i may be opened to supply an inert gas into the process chamber 201.

By performing this step (supply of reactant) under processing conditions to be described below, the second precursor adsorption layer formed in the recess with the first and second sacrificial films as sidewalls and the second precursor adsorption layer formed on at least a portion of the upper surface of each of the first and second sacrificial films may be modified respectively. When an oxidizing agent is used as the reactant, the second precursor adsorption layer may be oxidized to form an oxide layer containing a constituent element of the second precursor in the recess with the first and second sacrificial films as sidewalls and on at least a portion of the upper surface of each of the first and second sacrificial films.

After the second precursor adsorption layer is modified, the valves 243b and 243f are closed to stop the supply of reactant and the catalyst to the wafer 200. Then, by the above-described procedure, gaseous substances and the like remaining in the process chamber 201 are removed from the inside of the process chamber 201, and the process chamber 201 is purged with an inert gas.

### [Performing Predetermined Number of Times]

Then, a cycle including supply of the second precursor and supply of the reactant is performed a predetermined number of times (n_{B} times where n_{B} is an integer of 1 or 2 or more). As a result, as shown in FIG. 4C, a filling film may be formed in the recess with the first sacrificial film and the second sacrificial film as sidewalls, and on at least a portion of the upper surface of each of the first sacrificial film and the second sacrificial film. This cycle is performed until the recess is filled with the filling film. When a Si-containing substance is used as the second precursor and an oxidizing agent is used as the reactant, an oxide film, for example, a silicon oxide film (SiO film) may be formed as the filling film.

The second precursor may be, for example, the above-described Si-containing substances such as alkylaminosilane, aminosilane, chlorosilane, and the like. As the second precursor, one or more of these substances may be used.

The reactant (oxidizing agent) may be, for example, oxygen (O₂), ozone (O₃), water vapor (H₂O), nitrous oxide (N₂O), nitric oxide (NO), nitrogen dioxide (NO₂), carbon dioxide (CO₂), carbon monoxide (CO), or the like. As the reactant, one or more of these oxygen (O)-containing substances may be used. In this case, a reactant with a relatively weak oxidizing power may be used to suppress the first sacrificial film and the second sacrificial film from being substantially modified (oxidized) into an oxide film by the reactant. For example, a reactant with a weaker oxidizing power than the oxidizing agent used in step E to be described below may be used. However, when it is possible to use a reactant with a strong oxidizing power, such as when the first sacrificial film and the second sacrificial film with compositions resistant to oxidation is used, an oxidizing agent with a relatively strong oxidizing power exemplified in step E to be described below may also be used.

The catalyst may be, for example, pyridine (C₅H₅N), picoline (C₆H₇N), lutidine (C₇H₉N), triethylamine ((C₂H₅)₃N), or the like. As the catalyst, one or more of these amines may be used.

Processing conditions when supplying the second precursor and the catalyst in step B 1 are exemplified as follows:
Processing temperature: room temperature (25 degrees C) to 200 degrees C; specifically, room temperature to 150 degrees C;
Processing pressure: 1 to 2,000 Pa, specifically, 1 to 1,333 Pa;
Processing time: 1 to 180 seconds, specifically, 10 to 120 seconds;
Supply flow rate of second precursor: 0.001 to 2 slm; specifically, 0.01 to 1 slm; and
Supply flow rate of catalyst: 0.001 to 2 slm, specifically, 0.01 to 1 slm.

Processing conditions when supplying the reactant and the catalyst in step B 1 are exemplified as follows:
Processing pressure: 1 to 4,000 Pa, specifically, 1 to 1,333 Pa;
Supply flow rate of reactant: 0.001 to 2 slm, specifically, 0.01 to 1 slm; and
Supply flow rate of catalyst: 0.001 to 2 slm, specifically, 0.01 to 1 slm.
Other processing conditions may be the same as the processing conditions when supplying the second precursor and the catalyst.

After the formation of the filling film on the surface of the wafer 200 is completed, the inside of the process chamber 201 is purged, and gases and reaction by-products remaining in the process chamber 201 are removed from the inside of the process chamber 201 (after-purge). Thereafter, an internal atmosphere of the process chamber 201 is replaced with an inert gas (replacement of inert gas), and the internal pressure of the process chamber 201 is returned to the atmospheric pressure (returning to atmospheric pressure). Then, the processed wafers 200 are unloaded to the outside of the reaction tube 203 (boat unloading) and discharged from the boat 217 (wafer discharging). After the boat unloading, the lower end opening of the manifold 209 is sealed by the shutter 219s (shutter closing).

### [Step B2: Formation of Isolation Film]

Next, step B2 is performed on the wafer 200 after the wafer discharging, i.e., the wafer 200 after the filling film is formed on the surface of the wafer 200.

In step B2, a portion of the filling film formed in the recess formed on the surface of the wafer 200 is left as an isolation film, and other portions of the filling film are removed to expose at least portions of the first sacrificial film and the second sacrificial film. A partial removal of the filling film may be performed by an anisotropic etching in which for example, a plasma-excited etching gas such as a fluorocarbon (CF)-based gas is used. The anisotropic etching may be performed, for example, by using a first etching unit as a plasma etching apparatus, according to a known processing sequence and processing conditions. As the CF-based gas, for example, one or more selected from the group of a CF₄ gas, a C₄F₆ gas, a C₄F₈ gas, a CH₂F₂ gas, a CHF₃ gas, and the like may be used. The partial removal of the filling film is not limited to the case of being performed by anisotropic etching. When the above-described adjacent structure is formed on a flat portion of the surface of the wafer 200, the partial removal of the filling film may also be performed by, for example, a chemical mechanical polishing (CMP).

By performing step B2, as shown in FIG. 4D, the surface of the wafer 200 is in a state where the first sacrificial film, the isolation film, and the second sacrificial film, which are adjacent to one another sequentially, are exposed. The first sacrificial film and the second sacrificial film are physically isolated (separated) with the isolation film interposed therebetween. When the partial removal of the filling film is performed by anisotropic etching or CMP as described above, it is possible to allow the entire exposed surfaces of the first sacrificial film, the isolation film, and the second sacrificial film to become smooth surfaces (flat surfaces or curved surfaces) adjacent to one another without any steps.

As described above, the first sacrificial film and the second sacrificial film are made of, for example, nitride such as SiN or the like, and the isolation film is made of, for example, oxide such as SiO or the like. Further, as described above, each of the first sacrificial film and the second sacrificial film is formed under relatively low temperature processing conditions, and is made of nitride with a lower density than the first material and the third material which are the bases thereof. That is, the first sacrificial film and the second sacrificial film are made of a substance with a different composition from members (the isolation film, the first material, and the third material) existing around the films, or a substance with the same composition but a lower density. As described below, under predetermined etching conditions, the first sacrificial film and the second sacrificial film exhibit a predetermined etching selectivity with respect to the members existing around the films.

### (Step C: Formation of First and Second Recesses)

Next, step C is performed on the wafer 200 after the isolation film is formed between the first and second sacrificial films.

In step C, the first sacrificial film and the second sacrificial film are selectively removed with respect to the isolation film, the first material, and the third material. The selective removal of the first sacrificial film and the second sacrificial film may be performed by a known etching method capable of preferentially (selectively) etching a nitride such as SiN constituting the first sacrificial film and the second sacrificial film over various substances constituting the isolation film, the first material, and the third material. Examples of this method include wet etching in which a hot phosphoric acid (H₃PO₄, 70 to 90 degrees C) solution or a hydrogen fluoride solution is used as an etching agent, and dry etching in which a nitrogen fluoride (NF₃) gas or a carbon fluoride (CF₄) gas is used as an etching agent. These methods may be performed, for example, by using a second etching unit which is an etching apparatus. When an etching resistance of the first sacrificial film to the etching agent is lower than an etching resistance of each of the isolation film and the first material to the etching agent, and when an etching resistance of the second sacrificial film to the etching agent is lower than an etching resistance of each of the isolation film and the third material to the etching agent, the first sacrificial film and the second sacrificial film may be selectively removed with respect to the isolation film, the first material, and the third material.

By performing step C, as shown in FIG. 4E, a first recess with one side surface of the isolation film as a sidewall and the surface of the first material as a bottom surface, and a second recess with the other side surface of the isolation film as a sidewall and the surface of the second material as a bottom surface may be formed on the surface of the wafer 200. The first recess and the second recess formed on the surface of the wafer 200, i.e., the isolation film and the like constituting the side surfaces of these recesses, may be suitably used as a frame (a mold body configured to control a shape and a size of a film formed inside the recess) when forming the film inside the recesses in step D1 to be described below. Further, the isolation film constituting the side surfaces of these recesses, that is, the first recess and the second recess, may also be suitably used as an isolator (separator) that physically and electrically isolates the films formed inside the recesses.

In step A2, the first sacrificial film is formed to protrude toward the surface of the second material beyond the boundary between the surface of the second material and the surface of the first material, such that in step C, the first recess may be formed so as to protrude toward the surface of the second material beyond the boundary. Further, in step A2, by forming the second sacrificial film so as to protrude toward the surface of the second material beyond the boundary between the surface of the second material and the surface of the third material, it is possible to form, in step C, the second recess so as to protrude toward the surface of the second material beyond the boundary. In other words, according to the embodiments of the present disclosure, it is possible to form the first recess and the second recess so that the surface of each of the first material and the third material are not covered by the isolation film.

### (Step D)

Subsequently, the following steps D1 and D2 are performed on the wafer 200 after the first and second recesses are formed on the surface of the wafer 100. Step D1 is started after the above-described loading sequence (from the wafer charging and the boat loading to the pressure regulation and temperature regulation) is performed again, the wafer 200 as an intermediate product obtained by performing steps A to C is loaded into the process chamber 201 again, and the pressure regulation and temperature regulation in the process chamber 201 are completed.

### [Step D1: Formation of Dielectric Film]

In this step, the following steps (supply of third precursor and supply of reactant) are performed on the wafer 200. For example, an oxidizing agent may be used as the reactant.

### [Supply of Third Precursor]

In this step, the valve 243e is opened to supply a third precursor to the wafer 200. At this time, the valves 243g to 243i may be opened to supply an inert gas into the process chamber 201.

By performing this step (the supply of third precursor) under processing conditions to be described below, it is possible to form a third precursor adsorption layer in the first and second recesses formed on the surface of the wafer 200 and on at least a portion of the upper surface of the isolation film formed on the surface of the wafer 200. The third precursor adsorption layer contains at least a portion of a molecular structure of a molecule constituting the third precursor.

After the third precursor adsorption layer is formed, the valve 243e is closed to stop the supply of third precursor to the wafer 200. Then, by the above-described sequence, gaseous substances and the like remaining in the process chamber 201 are removed from the inside of the process chamber 201, and the inside of the process chamber 201 is purged with an inert gas (purging).

### [Supply of Reactant]

In this step, the valve 243b is opened to supply a reactant to the wafer 200. At this time, the valves 243g to 243i may be opened to supply an inert gas into the process chamber 201.

By performing this step (the supply of reactant) under processing conditions to be described below, it is possible to modify the third precursor adsorption layer formed in the first and second recesses, and the third precursor adsorption layer formed on at least a portion of the upper surface of the isolation film formed on the surface of the wafer 200, respectively. When an oxidizing agent is used as the reactant, the third precursor adsorption layer may be oxidized, and an oxide layer containing a constituent element of the third precursor may be formed in the first and second recesses and on at least a portion of the upper surface of the isolation film formed on the surface of the wafer 200.

After the third precursor adsorption layer is modified, the valve 243b is closed to stop the supply of reactant to the wafer 200. Then, by the above-described sequence, gaseous substances and the like remaining in the process chamber 201 are removed from the inside of the process chamber 201, and the inside of the process chamber 201 is purged with an inert gas.

### [Performing Predetermined Number of Times]

Then, a cycle including: the supply of third precursor; and the supply of reactant is performed a predetermined number of times (n_{D} times where no is an integer of 1 or 2 or more). As a result, as shown in FIG. 5A, it is possible to form a film that fills the first recess and the second recess and covers at least a portion of the upper surface of the isolation film. This cycle is performed until the recesses are filled with a dielectric film. When a metal-containing substance is used as the third precursor and an oxidizing agent is used as the reactant, this film becomes a dielectric film which is an oxide film such as an aluminum oxide film (AlO film), a titanium oxide film (TiO film), a hafnium oxide film (HfO film), a zirconium oxide film (ZrO film) or the like, i.e., a metal oxide film with a higher electron trap density than a SiN film. The dielectric film in the present disclosure is not limited to the oxide film, and a nitride film containing a similar metal element may also be used as the dielectric film. However, when step E to be described below is further performed, the oxide film may be used as the dielectric film.

The third precursor may be, for example, aluminum trichloride (AlCl₃), trimethylaluminum (Al(CH₃)₃), titanium tetrachloride (TiCl₄), hafnium tetrafluoride (HfF₄), tetrakisethylmethylaminohafnium (Hf[N(CH₃)(CH₂CH₃)]₄), zirconium tetrafluoride (ZrF₄), tetrakisethylmethylaminozirconium (Zr[N(CH₃)Cp]₄), or the like. As the third precursor, one or more selected from the group of these substances, i.e., substances containing metal elements such as aluminum (Al), titanium (Ti), hafnium (Hf), zirconium (Zr), and the like (organic metals or metal halides) may be used.

As the reactant (oxidizing agent), one or more of the O-containing substances described above may be used.

Processing conditions when supplying the third precursor in step D1 are exemplified as follows:
Processing temperature: room temperature (25 degrees C) to 700 degrees C, specifically, 350 to 550 degrees C;
Processing pressure: 1 to 2,000 Pa, specifically, 1 to 1,333 Pa;
Processing time: 1 to 180 seconds, specifically, 10 to 120 seconds;
Supply flow rate of third precursor: 0.001 to 2 slm, specifically, 0.01 to 1 slm; and
Supply flow rate of inert gas (for each gas supply pipe): 0 to 20 slm.

Processing conditions when supplying the reactant in step D1 are exemplified as follows:
Processing pressure: 1 to 4,000 Pa, specifically, 1 to 1,333 Pa; and
Supply flow rate of reactant: 0.01 to 20 slm, specifically, 0.01 to 10 slm.

The other processing conditions may be the same as those used when supplying the third precursor.

The reactant may be a nitriding agent. The reactant may be one or more of the above-described N-containing substances. When a Si-containing substance is used as the third precursor and a nitriding agent is used as the reactant, a SiN film may be formed as the dielectric film.

After step D1 is completed, the above-described unloading sequence (from after-purge to wafer discharging) is performed again, and the wafers 200 with the dielectric film formed on their surfaces are unloaded from the process chamber 201 and discharged from the boat 217.

### [Step D2: Formation of First and Second Dielectric Films]

Next, step D2 is performed on the wafer 200 after the wafer discharging, i.e., the wafer 200 as an intermediate product after the dielectric film is formed on the surface of the wafer 200 by performing step D1.

In step D2, portions of the dielectric film formed on the surface of the wafer 200 that fill the first and second recesses are left as a first dielectric film and a second dielectric film, respectively, and the remaining portions of the dielectric film are removed. A partial removal of the dielectric film may be performed by various methods exemplified in step B2, such as anisotropic etching by a plasma-excited CF-based gas, CMP, and the like. These methods may be performed, for example, by using a first etching unit as a plasma etching apparatus.

By performing step D2, as shown in FIG. 5B, the surface of the wafer 200 is in a state in which the first dielectric film, the isolation film, and the second dielectric film, which are adjacent to one another sequentially, are exposed. The first dielectric film and the second dielectric film are physically and electrically isolated (separated) with the isolation film interposed therebetween. When the partial removal of the dielectric film is performed by anisotropic etching or CMP as described above, it is possible to allow the entire exposed surfaces of the first dielectric film, the isolation film, and the second dielectric film to become smooth surfaces (flat surfaces or curved surfaces) adjacent to one another without any steps. An electron trap density of each of the first dielectric film and the second dielectric film made of a metal oxide film such as an AlO film or the like is larger than that of a SiN film with the same film thickness.

In step C, by forming the first recess so as to protrude toward the surface of the second material beyond the boundary between the surface of the second material and the surface of the first material, it is possible to form the first dielectric film so as to protrude toward the surface of the second material beyond the boundary in step D2. Further, in step C, by forming the second recess so as to protrude toward the surface of the second material beyond the boundary between the surface of the second material and the surface of the third material, it is possible to form the second dielectric film so as to protrude toward the surface of the second material beyond the boundary in step D2.

### (Step E: Formation of First Substituted Oxide Film and Second Substituted Oxide Film)

Next, step E is performed on the wafer 200 after the first dielectric film and the second dielectric film are formed on the surface of the wafer 200. Step E is started after the above-described loading sequence (from wafer charging and boat loading to pressure regulation and temperature regulation) is performed again, the wafer 200 as an intermediate product obtained by performing steps A to D2 is loaded into the process chamber 201 again, and the pressure regulation and temperature regulation in the process chamber 201 are completed.

In this step, the valve 243b is opened to supply a reactant containing oxygen (i.e., an oxidizing agent) to the wafer 200. At this time, the valves 243g to 243i may be opened to supply an inert gas into the process chamber 201.

By performing step E under the processing conditions to be described below, a portion of the first material in contact with the interface between the first material and the first dielectric film through the first dielectric film may be modified (oxidized) into a first substituted oxide film, and a portion of the third material in contact with the interface between the third material and the second dielectric film through the second dielectric film can be modified (oxidized) into a second substituted oxide film. The first substituted oxide film and the second substituted oxide film are constituted as, for example, a SiO film or a SiON film. Further, in step E, it is possible to further improve characteristics of the isolation film, the first dielectric film, and the second dielectric film as the oxide film without impairing the characteristics of the isolation film, the first dielectric film, and the second dielectric film. For example, it is possible to re-oxidize (additionally oxidize) the isolation film, the first dielectric film, and the second dielectric film, to desorb impurities from these films, densify these films, and improve insulating properties of these films.

After the above-described modification is completed, the valve 243b is closed to stop the supply of oxidizing agent into the process chamber 201. Then, by the above-described sequence, gaseous substances and the like remaining in the process chamber 201 are removed from the inside of the process chamber 201, and the inside of the process chamber 201 is purged with an inert gas.

The oxidizing agent may be, for example, an oxygen-containing substance such as ozone (O₃), O₂ + hydrogen (H₂), O₂ + deuterium (D₂), O₃ + H₂, O₃ + D₂, hydrogen peroxide (H₂O₂), and O₂ or O₃ excited to a plasma state. As the oxidizing agent, one or more of these substances may be used. As used herein, description of two substances together, such as "O₂ + H₂," means a mixture of O₂ and H₂. When the mixture is supplied, two substances may be mixed (premixed) in a supply pipe and then supplied into the process chamber 201, or two substances may be separately supplied into the process chamber 201 via different supply pipes and mixed (post-mixed) in the process chamber 201. When the first substituted oxide film and the second substituted oxide film may be formed through the first dielectric film and the second dielectric film by regulating the processing conditions and the like, it is also possible to use an oxidizing agent with a relatively weak oxidizing power as exemplified in the above-described step B.

Processing conditions when supplying the oxidizing agent in step E are exemplified as follows:
Processing temperature: 350 to 1,000 degrees C, specifically, 400 to 650 degrees C;
Processing pressure: 1 to 105,000 Pa, specifically, 10 to 10,000 Pa;
Processing time: 1 to 10,000 seconds, specifically, 5 to 3,600 seconds;
Supply flow rate of oxidizing agent: 0.01 to 10 slm, specifically, 0.1 to 5 slm; and
Supply flow rate of inert gas (for each gas supply pipe): 0 to 20 slm.

### (Step F: Formation of Tunnel Oxide Film and Channel Film)

Next, step F is performed on the wafer 200 after the first substituted oxide film and the second substituted oxide film are formed.

In this step, a tunnel oxide film and a channel film are sequentially stacked on the surface of each of the isolation film, the first dielectric film, and the second dielectric film formed on the wafer 200. The tunnel oxide film and the channel film may be respectively formed by a known method which is known as a part of a manufacturing process of a memory cell in a flash memory. Step F may be performed in the above-described process chamber 201 where step E is performed (in-situ), or may be performed in a process chamber of another substrate processing apparatus (ex-situ).

Through steps A to F, a stacked structure shown in FIG. 5D is manufactured.

This stacked structure may be suitably used, for example, as a part of components of a memory cell of a flash memory. That is, the first dielectric film and the second dielectric film formed by the above-described method are higher in electron trap density than a SiN film by being constituted as metal oxide films, and are precisely formed with a high dimensional accuracy so as to be formed in an appropriate shape, such that each of the first dielectric film and the second dielectric film may be suitably used as a charge trap layer of a memory cell. Further, since the isolation film is made of an oxide film such as a SiO film, they may be suitably used as an isolation layer that insulates adjacent charge trap layers in a memory cell of a flash memory. Further, since the first substituted oxide film and the second substituted oxide film are made of an oxide film (SiO film or SiON film), each of the first substituted oxide film and the second substituted oxide film may be suitably used as a blocking layer that suppresses carrier leakage from a charge trap layer.

### (3) Effects of Embodiments of the present disclosure

According to the embodiments of the present disclosure, one or more of the following effects may be obtained.
(a) By performing the above-described steps A to C, it is possible to selectively form recesses (a first recess and a second recess) on a surface of a base made of a predetermined material (a first material and a third material) in a substrate with a structure in which surfaces of the first to third materials are adjacent to one another sequentially. The recesses thus formed may be suitably used, for example, as a frame (mold) when forming films therein or as an isolator (separator) that physically and electrically isolates the films formed therein. This makes it possible to precisely form a film on the substrate. Further, by using the recesses as frames and forming, for example, dielectric films respectively therein, the films formed in the recesses may be suitably used as a charge trap layer of a memory cell included in a flash memory.
(b) Since the second material is oxide, and each of the first and third materials is at least one selected from the group of oxide with a smaller oxygen content ratio than the second material and non-oxide, the above-described effects may be obtained more reliably. For example, since each of the first and third materials is a nitride such as SiN, and the second material is oxide such as SiO, the first and second sacrificial films may be selectively formed on the surfaces of the first and third materials, respectively, by utilizing an OH termination (a hydroxyl termination) selectively formed on the surface of the second material, which is oxide. Further, since the first to third materials are the above-described materials, a structure in which the first to third materials are adjacent to one another sequentially may be suitably used, for example, as a part of components of a memory cell of a flash memory.
(c) The above-described effects may be obtained more reliably by using an oxide film such as a SiO film as the isolation film. Further, by using the oxide film such as the SiO film as the isolation film, the isolation film may be suitably used as, for example, an isolation layer that insulates adjacent charge trap layers in a memory cell of a flash memory.
(d) By performing the above-described steps A1 and A2 in step A, it becomes possible to selectively and efficiently form each of the first sacrificial film and the second sacrificial film on the surface of the second material. As a result, in the subsequent step C, it becomes possible to efficiently form each of the first recess and the second recess with high dimensional accuracy.
(e) In step A, by forming the first sacrificial film so as to protrude toward the surface of the second material beyond the boundary between the surface of the second material and the surface of the first material, and by forming the second sacrificial film so as to protrude toward the surface of the second material beyond the boundary between the surface of the second material and the surface of the third material, it is possible to appropriately regulate a shape or a size of each of the first recess and the second recess formed in step C. For example, by forming the first sacrificial film and the second sacrificial film in step A as described above, it is possible to form the first recess and the second recess without the surface of each of the first material and the third material being covered by the isolation film. Thus, the shape or the size of each of the first dielectric film formed in the first recess and the second dielectric film formed in the second recess in step D may be set to be suitable when the first and second dielectric films are used as charge trap layers of a memory cell.
(f) When performing the above-described steps B 1 and B2 in step B, the isolation film is formed by using, as a frame body, the recess with the first sacrificial film and the second sacrificial film as sidewalls, such that the isolation film may be formed with a good controllability and a high dimensional accuracy. Further, by covering at least a portion of the upper surface of each of the first sacrificial film and the second sacrificial film with the filling film in step B 1 and going through the process of removing undesired portions of the filling film in step B2, the isolation film may be formed as a void-free film which fills the recess without gaps. As a result, the isolation film may be suitably used, for example, as an isolation layer that insulates adjacent charge trap layers.

By constituting the filling film by an oxide film such as a SiO film, a film obtained by processing the filling film may be suitably used, for example, as an isolation film for a charge trap layer.

In addition, in step B 1, a cycle including: supply of second precursor; and supply of reactant is performed a predetermined number of times, such that the filling film may be formed with a good step coverage and a good controllability. Thus, a quality of the isolation film may be improved, and a film obtained by processing the isolation film may be suitably used as, for example, an isolation film for a charge trap layer.

(g) In step D, by forming the first dielectric film in the first recess and the second dielectric film in the second recess respectively, the first recess and the second recess may function as frames (molds) when forming the first dielectric film and the second dielectric film, respectively. Thus, a shape or a dimension of each of the first dielectric film and the second dielectric film thus obtained may be set to be suitable for, for example, a charge trap layer of a memory cell. Further, a structure may be formed in which an isolation film is disposed between the first dielectric film and the second dielectric film, as an isolator (separator) that isolates the films. As a result, for example, when the first dielectric film and the second dielectric film are applied as charge trap layers of a memory cell, the isolation film may suppress an electrical interference between the charge trap layers.

Since each of the first and second dielectric films is larger in electron trap density than a silicon nitride film, the first and second dielectric films may be suitably used as, for example, charge trap layers of a memory cell.

(h) In step D, by forming the first dielectric film and the second dielectric film in the order of steps D1 and D2, the first recess may be formed to be filled with the first dielectric film without any gaps, and the second recess may be formed to be filled with the second dielectric film without any gaps, respectively. As a result, these films may be suitably used, for example, as charge trap layers of a memory cell.

(i) Since each of the first dielectric film and the second dielectric film is an oxide film such as a metal oxide film, each of the first dielectric film and the second dielectric film may be suitably used, for example, as a charge trap layer of a memory cell.

Further, since each of the first and second dielectric films is an oxide film such as a metal oxide, even in a case where a portion of the first material or a portion of the third material are oxidized (modified) through the first dielectric film or the second dielectric film when forming the first substituted oxide film or a second substituted oxide film in step E, characteristics of the first and second dielectric films as the oxide films may be maintained. In contrast, for example, in a case where the first dielectric film or the second dielectric film is a nitride film, when a portion of the first material or a portion of the third material is oxidized through the first dielectric film or the second dielectric film, at least a part of nitrogen in the first and second dielectric films is desorbed, which may make it difficult to maintain characteristics of the first and second dielectric films as the nitride films.

(j) By performing step E of supplying the oxidizing agent to the wafer 200 after step D, the first substituted oxide film or the second substituted oxide film as the oxide film with high insulating properties may be formed to be adjacent to the first dielectric film or the second dielectric film. Further, by performing modification (oxidation) through the first dielectric film or the second dielectric film, it is possible to improve a film quality of the first dielectric film or the second dielectric film. Thus, these films may be made more suitable for, for example, charge trap layers of a memory cell.

(k) In a case where the first and second dielectric films formed by the methods in the present disclosure are used, for example, as films constituting charge trap layers of a memory cell, it is possible to improve a performance of a flash memory device.

(l) Since the etching resistance of the first sacrificial film to the etching agent used in step C is lower than the etching resistance of the first material to the etching agent, and the etching resistance of the second sacrificial film to the etching agent is lower than the etching resistance of the third material to the etching agent, the etching of the surface of each of the first material and the third material may be suppressed, and each of the first recess and the second recess may be formed with a good controllability and a high dimensional accuracy in step C.

Since each of the first sacrificial film and the second sacrificial film is constituted by a film containing a specified element such as Si and at least one selected from the group of nitrogen and carbon, the etching resistance of the first and second sacrificial films may be appropriately reduced, and the above-described effects may be effectively obtained.

(m) The above-described effects may be obtained similarly even when using a predetermined substance arbitrarily selected among the various modifying agents, the various first to third precursors, the various reactants (oxidizing agent and nitriding agent), and the various inert gases described above.

### <Other Embodiments of the Present Disclosure>

The embodiments of the present disclosure are specifically described above. However, the present disclosure is not limited to the above-described embodiments, and various modifications may be made without departing from the spirit of the present disclosure.

For example, after performing step A2 (formation of the first and second sacrificial films) and before starting step B1 (formation of the filling film), an oxidizing agent such as water vapor (H₂O) or oxygen (O₂) may be supplied to the wafers 200 in the process chamber 201. For example, a processing sequence and processing conditions in such a case may be the same as the processing procedure and processing conditions when supplying the reactant in step B1. Further, after performing step A2 and before starting step B 1, the wafers 200 may be unloaded from the process chamber 201 and may be exposed to the ambient air.

Even in these cases, the same effects as in the above-described embodiments may be obtained. Further, in such cases, it is possible to remove and/or invalidate the first adsorption inhibition layer remaining on the surface of the wafer 200 before starting step B, and it becomes possible to form the filling film efficiently with a good quality in step B 1 performed thereafter.

Further, for example, for the wafer 200 with the first recess and the second recess formed on the surface of the wafer 200, step D may include:
(d-1) step D1' of selectively forming a second adsorption inhibition layer (second inhibitor layer) that inhibits adsorption of a third precursor gas on the surface of the isolation film with respect to each of the surface of the first material and the surface of the third material; and
(d-2) step D2' of supplying the third precursor gas to the wafer 200 to form a first dielectric film on the surface of the first material and a second dielectric film on the surface of the third material respectively.

The process sequence and the process conditions in step D1' may be, for example, the same as the process sequence and the process conditions in step A1 (formation of the first adsorption inhibition layer) described above. The process sequence and the process conditions in step D2' may be, for example, the same as the process sequence and the process conditions in step D1 (formation of the dielectric film) described above.

Even in these cases, the same effects as in the above-described embodiments may be obtained. Further, in such cases, it is possible to selectively and efficiently form each of the first and second dielectric films on the surface of the isolation film. Further, after the formation of the first and second dielectric films, it is possible to omit step D2 of removing undesired dielectric films, thereby improving a productivity of a device.

When steps D1' and D2' are performed in step D, step D2' may be performed until the first recess is filled with the first dielectric film and the second recess is filled with the second dielectric film respectively. By filling the first recess with the first dielectric film without any gaps and filling the second recess with the second dielectric film without any gaps, each of the first dielectric film and the second dielectric film may be suitably used, for example, as a charge trap layer of a memory cell.

For example, in the above-described embodiments, the example is described in which the O-containing substance exemplified as the reactant (oxidizing agent) in step B1 is used as the reactant used in step D1. The present disclosure is not limited thereto, and the O-containing substance with a relatively strong oxidizing power exemplified as the oxidizing agent in step E1 may be used as the reactant used in step D1. In this case, in step D1, the first material and the third material may be modified (oxidized) in parallel with the formation of the dielectric film to form the first substituted oxide film and the second substituted oxide film. That is, step E1 may be omitted, or the processing time in step E may be shortened. However, when step D1 and step E1 are performed in separate processes as in the above-described embodiments, it is possible to regulate the thicknesses of the first substituted oxide film and the second substituted oxide film in step E1 with a good controllability.

Recipes used in each process may be provided individually according to the processing contents and may be recorded and stored in the memory 121c via a telecommunication line or the external memory 123. Moreover, at the beginning of each process, the CPU 121a may properly select an appropriate recipe from the recipes recorded and stored in the memory 121c according to the processing contents. Thus, it is possible for a processing apparatus to form films of various kinds, composition ratios, qualities, and thicknesses with enhanced reproducibility. Further, it is possible to reduce an operator's burden and to quickly start each process while avoiding an operation error.

The recipes described above are not limited to newly-provided ones but may be provided, for example, by modifying existing recipes that are already installed in the processing apparatus. When the recipes are modified, the modified recipes may be installed in the processing apparatus via a telecommunication line or a recording medium storing the recipes. In addition, the existing recipes already installed in the existing processing apparatus may be directly modified by operating the input/output device 122 of the processing apparatus.

Examples in which a film is formed by using a batch-type processing apparatus configured to process a plurality of substrates at a time are described in the above-described embodiments. The present disclosure is not limited to the above-described embodiments, but may be suitably applied, for example, to a case where a film is formed by using a single-wafer type processing apparatus configured to process a single substrate or several substrates at a time. In addition, examples in which a film is formed by using a processing apparatus provided with a hot-wall-type process furnace are described in the above-described embodiments. The present disclosure is not limited to the above-described embodiments, but may be suitably applied to a case where a film is formed by using a substrate processing apparatus provided with a cold-wall-type process furnace.

In the above-described embodiments of the present disclosure, the case is described where a series of processing sequences of steps A1, A2, and B 1 are performed continuously (in situ) in the same process chamber of the same processing apparatus, and steps D1 and E are performed in the same process chamber of the same processing apparatus. The present disclosure is not limited to the above-described embodiments. For example, any one step of steps A1, A2, B 1, D1 and E and any other step thereof may be performed in different process chambers of different processing apparatuses (ex-situ), or may be respectively performed in different process chambers of the same processing apparatus.

Even when these processing apparatuses are used, each process may be performed under the same processing sequences and processing conditions as in the above-described embodiments and modifications. The same effects as in the above-described embodiments and modifications may be obtained.

The above-described embodiments or modifications may be used in combination as appropriate. Processing sequences and processing conditions in such cases may be, for example, the same as the processing sequences and processing conditions of the above-described embodiments or modifications.

According to the present disclosure in some embodiments, it is possible to precisely form a film on a substrate.

While certain embodiments are described above, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate, comprising:
(a) in the substrate with a structure in which a surface of a first material, a surface of a second material, and a surface of a third material are adjacent to one another sequentially, selectively forming a first sacrificial film on the surface of the first material and a second sacrificial film on the surface of the third material respectively with respect to the surface of the second material;
(b) forming an isolation film in a recess with the first sacrificial film and the second sacrificial film as sidewalls; and
(c) forming a first recess with one side surface of the isolation film as a sidewall and the surface of the first material as a bottom surface, and a second recess with the other side surface of the isolation film as a sidewall and the surface of the second material as a bottom surface by selectively removing the first sacrificial film and the second sacrificial film with respect to the isolation film, the first material, and the third material.

2. The method of Claim 1, wherein the second material is oxide, and each of the first material and the third material is at least one selected from the group of oxide with a lower oxygen content ratio than the second material and non-oxide.

3. The method of Claim 1, wherein each of the first material and the third material is nitride, and the second material is oxide.

4. The method of Claim 2 or 3, wherein the isolation film is an oxide film.

5. The method of any one of Claims 1 to 4, wherein (a) includes:
(a-1) selectively forming a first adsorption inhibition layer that inhibits adsorption of a first precursor on the surface of the second material with respect to each of the surface of the first material and the surface of the third material; and
(a-2) forming the first sacrificial film on the surface of the first material and the second sacrificial film on the surface of the third material respectively by supplying the first precursor to the substrate.

6. The method of any one of Claims 1 to 5, wherein in (a), the first sacrificial film is formed to protrude toward the surface of the second material beyond a boundary between the surface of the second material and the surface of the first material.

7. The method of any one of Claims 1 to 6, wherein (b) includes:
(b-1) forming a filling film that fills the recess and covers at least a portion of an upper surface of each of the first sacrificial film and the second sacrificial film; and
(b-2) leaving a portion of the filling film formed in the recess as the isolation film and removing other portions of the filling film.

8. The method of any one of Claims 1 to 7, further comprising:
(d) forming a first dielectric film in the first recess and a second dielectric film in the second recess respectively.

9. The method of Claim 8, wherein (d) includes:
(d-1) forming a dielectric film that fills the first recess and the second recess and covers at least a portion of an upper surface of the isolation film; and
(d-2) leaving portions of the dielectric film filling the first recess and the second recess as the first dielectric film and the second dielectric film respectively, and removing other portions of the dielectric film.

10. The method of Claim 8, wherein (d) includes:
(d-1) selectively forming a second adsorption inhibition layer that inhibits adsorption of a third precursor on the surface of the isolation film with respect to each of the surface of the first material and the surface of the third material; and
(d-2) supplying the third precursor to the substrate to form the first dielectric film on the surface of the first material and the second dielectric film on the surface of the third material respectively.

11. The method of any one of Claims 8 to 10, further comprising:
(e) after (d), supplying an oxidizing agent to the substrate to modify a portion of the first material in contact with an interface between the first material and the first dielectric film through the first dielectric film into a first substituted oxide film.

12. The method of any one of Claims 8 to 11, wherein each of the first dielectric film and the second dielectric film is a film constituting a charge trap layer of a memory cell.

13. A method of manufacturing a semiconductor device, comprising the method of Claim 1.

14. A program that causes, by a computer, a substrate processing apparatus to perform a process comprising:
(a) in a substrate with a structure in which a surface of a first material, a surface of a second material, and a surface of a third material are adjacent to one another sequentially, selectively forming a first sacrificial film on the surface of the first material and a second sacrificial film on the surface of the third material respectively with respect to the surface of the second material;
(b) forming an isolation film in a recess with the first sacrificial film and the second sacrificial film as sidewalls; and
(c) forming a first recess with one side surface of the isolation film as a sidewall and the surface of the first material as a bottom surface, and a second recess with the other side surface of the isolation film as a sidewall and the surface of the second material as a bottom surface by selectively removing the first sacrificial film and the second sacrificial film with respect to the isolation film, the first material, and the third material.

15. A substrate processing apparatus used in the method of Claim 1, comprising:
a first precursor supply system configured to supply a first precursor to the substrate; and
a controller configured to be capable of controlling the first precursor supply system so as to perform supplying the first precursor to the substrate to form the first sacrificial film on the surface of the first material and the second sacrificial film on the surface of the third material respectively.
